# EUROPEAN PATENT APPLICATION

(11) **EP 4 657 500 A1**
(43) Date of publication of application: **03.12.2025**
(21) Application number: 25168147.4
(22) Date of filing: 03.04.2025
(51) Int. Cl.: H01L 21/02, H01L 21/18, H01L 21/78

(54) **SIC LAYER TRANSFER VIA REMOTE EPITAXY**

(30) Priority: 31.05.2024 US 202463654459 P; 25.11.2024 US 202418958517
(71) Applicant: Semiconductor Components Industries, LLC, Scottsdale, AZ 85250 (US)
(72) Inventor: KOSTELNIK, Petr, 74401 Severomoravsky Kraj (CZ); KOCIAN, Karel, 74258 Pribor (CZ); NOVAK, Tomas, 75654 Zubri (CZ); VEMOLOVA, Hana, Valasske Meziri (CZ); DAS, Hrishikesh, Scarborough, ME 04074 (US)
(74) Representative: Manitz Finsterwald Patent- und Rechtsanwaltspartnerschaft mbB

(57) **Abstract**

A method for structure fabrication with silicon carbide (SiC) layer transfer via a remote epitaxy includes forming a van der Waals layer on a carbon face of a donor wafer, growing an epitaxial SiC layer on the van der Waals layer, and wafer bonding the epitaxial SiC layer to a handle wafer. The handle wafer is made of polycrystalline SiC. The method further includes separating the epitaxial SiC layer from the van der Waals layer to generate a final structure that includes the epitaxial SiC layer on the polycrystalline SiC of the handle wafer.

## Description

### CROSS-REFERENCE TO RELATED APPLICATIONS

The present application claims the benefit of priority to United States Provisional Application No. 63/654,459, filed on May 31, 2024, which is hereby incorporated by reference in its entirety for all purposes.

### TECHNICAL FIELD

The present disclosure relates generally to fabrication of thin semiconductor substrates, and in particular to silicon carbide layer transfer via a remote epitaxy.

### BACKGROUND

Silicon carbide (SiC) substrates define a significant cost of final SiC devices. Thinning the SiC substrate reduces the material costs at the expense of mechanical support in a push for ever-larger devices. Accordingly, those skilled in the art continue with research and development efforts in the field of providing thin SiC substrates for larger devices.

### SUMMARY

A method for structure fabrication with SiC layer transfer via a remote epitaxy is provided herein. The method includes forming a van der Waals layer on a carbon face of a donor wafer, growing an epitaxial SiC layer on the van der Waals layer, and wafer bonding the epitaxial SiC layer to a handle. The handle is made of polycrystalline SiC. The method includes separating the epitaxial SiC layer from the van der Waals layer to generate a final structure that includes the epitaxial SiC layer on the polycrystalline SiC of the handle wafer.

The above summary is not intended to represent every embodiment or aspect of the present disclosure. Rather, the foregoing summary exemplifies certain novel aspects and features as set forth herein. The above noted and other features and advantages of the present disclosure will be readily apparent from the following detailed description of representative embodiments and modes for carrying out the present disclosure when taken in connection with the accompanying drawings and the appended claims.

### BRIEF DESCRIPTION OF THE DRAWINGS

The drawings described herein are for illustrative purposes only, are schematic in nature, and are intended to be exemplary rather than to limit the scope of the disclosure.
FIG. 1 is a flow diagram of a fabrication method in accordance with one or more exemplary embodiments.
FIG. 2 is a schematic cross-sectional diagram of a first layer stacking option for an epitaxial layer stack in accordance with one or more exemplary embodiments.
FIG. 3 is a schematic cross-sectional diagram of a second layer stacking option for the epitaxial layer stack in accordance with one or more exemplary embodiments.
FIG. 4 is a schematic cross-sectional diagram of a third layer stacking option for the epitaxial layer stack in accordance with one or more exemplary embodiments.
FIG. 5 is a table of C-face epitaxial growth measurements in accordance with one or more exemplary embodiments.
FIG. 6 is a graph of a C-face epitaxial growth thickness profile as a function of radius in accordance with one or more exemplary embodiments.
FIG. 7 is a graph of a C-face epitaxial growth radial doping profiles in accordance with one or more exemplary embodiments.
FIG. 8 is a graph of a calibration curve in accordance with one or more exemplary embodiments.

The present disclosure may be modified or embodied in alternative forms, with representative embodiments shown in the drawings and described in detail below. Inventive aspects of the present disclosure are not limited to the disclosed embodiments. Rather, the present disclosure is intended to cover alternatives falling within the scope of the disclosure as defined by the appended claims.

### DETAILED DESCRIPTION

Embodiments of the disclosure generally define a method of fabricating a final structure using a delamination layer and direct transfer of an epitaxial layer from donor wafer onto a handle wafer. The layer transfer technologies enables utilization of expensive monocrystalline prime 4H-SiC wafers with high efficiency electrical properties while providing low-cost handle wafers for mechanical support. The handle wafers are generally made of a sintered, highly doped, polycrystalline SiC wafers. Therefore, a coefficient of thermal expansion is the same for both the transferred epitaxial layers and the handle wafers. Furthermore, the high doping of the handle wafers generally improves the "on" resistances (R_{ON}) of SiC devices subsequently fabricated in (or on) the transferred epitaxial layers. With reference to the drawings, wherein like reference numbers refer to the same or similar components throughout the several views.

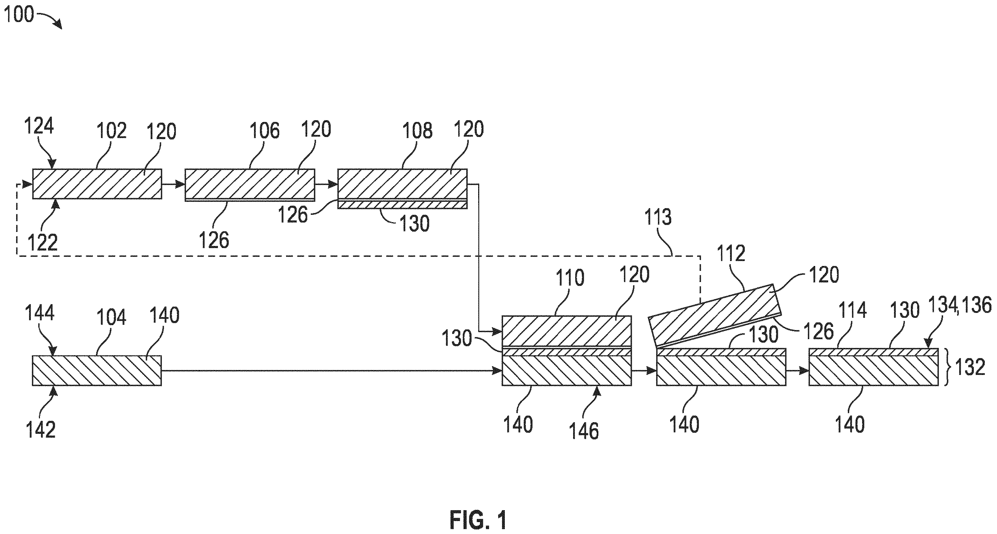

Referring to FIG. 1, a flow diagram of an example fabrication method is shown in accordance with one or more exemplary embodiments. The method (or process) 100 generally includes steps 102 to 114, as illustrated. The sequence of steps is shown as a representative example. Other step orders may be implemented to meet the criteria of a particular application. Starting materials for the method 100 include a donor wafer 120 and a handle wafer 140.

The donor wafer 120 implements a monocrystalline 4H-SiC wafer (where "4H" is the hexagon polytype, the number 4 indicates the layer stacking order, and the letter H indicates the hcp Bravais lattice). The donor wafer 120 has a carbon-face side 122 and a silicon-face side 124. The silicon-face side 124 is opposite the carbon-face side 122. In the step 102, the carbon-face side 122 of the donor wafer 120 may be cleaned and polished. The cleaning may include a hydrogen etching of several hundreds of nanometers to prepare the carbon-face side 122 for an epitaxy growth and to reduce a density of defects. The hydrogen etching may be done by exposure of the carbon-face side 122 of the donor wafer 120 to hydrogen gas while the donor wafer 120 is heated to a high temperature. In various embodiments, the high temperature may be in a range of 1500 °C to 1700 °C.

The handle wafer 140 implements a polycrystalline SiC wafer. The handle wafer 140 has a first side 142 and a second side 144. The first side 142 is opposite the second side 144. In the step 104, the second side 144 of the handle wafer 140 may be polished and cleaned.

In the step 106, a van der Waals layer 126 is formed directly or indirectly on the carbon-face side 122 of the donor wafer 120. The van der Waals layer 126 is generally a two-dimensional layer that provides a weak force when bonded with the second side 144 of the handle wafer 140. The van der Waals layer 126 may be coupled to surfaces weakly (by the active valence electrons that create the Van der Waals forces) to retain the two dimensional electronic band structure. In various embodiments, the van der Waals layer 126 implements a transfer layer or a delamination layer.

The van der Waals layer 126 may have a thickness of approximately 1.0 nanometers (e.g., in the range of approximately 0.3 nanometers to approximately 1.8 nanometers). Other thicknesses may be implemented to meet the design criteria of a particular application. The van der Waals layer 126 may include, but is not limited to, a graphene layer.

The van der Waals layer 126 may be formed as a graphene layer by SiC high temperature decomposition in an Argon (Ar) atmosphere inside a vacuum chamber or a chemical vapor deposition. For example, the van der Waals layer 126 may be formed under a flowing an Ar ambient gas of approximately 20 liters per minute, at 100 millibars (mbar), and at a temperature of approximately 1550 degrees Celsius (°C) to 1650 °C. In various embodiments, the van der Waals layer 126 may be a hexagonal Boron nitrite layer, or other two-dimensional van der Waals layers.

In the step 108 an epitaxial SiC layer 130 is formed on the van der Waals layer 126. The epitaxial SiC layer 130 buries the van der Waals layer 126 between the epitaxial SiC layer 130 and the original donor wafer 120. Formation of the epitaxial SiC layer 130 generally takes advantage of a remote epitaxial formation process where the thin van der Waals layer 126 allows the penetration of the potential field of the original donor wafer 120 and replication of the crystallographic structure in the epitaxial SiC layer 130.

The epitaxial SiC layer 130 may have a thickness of approximately 10 micrometers (e.g., in the range of approximately 5 micrometers to approximately 15 micrometers). Other thicknesses may be implemented to meet the design criteria of a particular application.

In the step 110, a direct wafer bonding is performed between the donor wafer 120 and the handle wafer 140 to create a silicon carbide structure 146. The bonding generally takes place between the epitaxial SiC layer 130 of the donor wafer 120 and the second side 144 of the handle wafer 140. The epitaxial SiC layer 130 is usually strained due to a doping mismatch with the heavily doped handle wafer 140. The wafer bonding step 110 may include an annealing process, with elevated temperature at or above 400 °C, to help join the epitaxial SiC layer 130 to the handle wafer 140. In various embodiments, the elevated temperature may be held for approximately 60 minutes to 180 minutes.

In the step 112, the donor wafer 120 is separated from the handle wafer 140 where the van der Waals layer 126 joins the epitaxial SiC layer 130. The van der Waals layer 126 remains with the donor wafer 120. The epitaxial SiC layer 130 remains with the handle wafer 140. The weak forces between the van der Waals layer 126 and the epitaxial SiC layer 130 may be overcome by the application of ultrasound, a stressor layer incorporated during the fabrication, and/or the like. At the completion of the step 112, the remaining donor wafer 120 may be cleaned and recycled in the step 113 for use in another round of the method 100 to create another final structure 132.

In the step 114, the final structure 132 is established. The final structure generally includes the handle wafer 140 and the epitaxial SiC layer 130. A touch up chemical mechanical polishing (CMP) of an outer surface 134 of the epitaxial SiC layer 130 may be performed in the step 114 to produce an exposed silicon face 136 (or final surface). The touch up CMP provides a quick, low-removal polishing step that is optimized for scratch removal and low surface roughness.

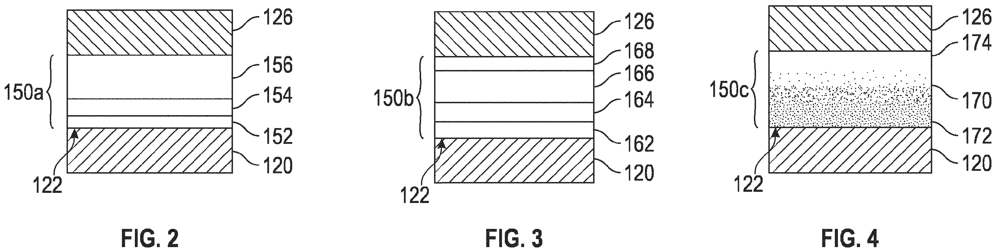

Referring to FIG. 2, a schematic cross-sectional diagram of a first example layer stacking option for an epitaxial layer stack 150a is shown in accordance with one or more exemplary embodiments. The epitaxial layer stack 150a may be formed on the donor wafer 120 before the van der Waals layer 126 is formed.

In the embodiment illustrated, the first epitaxial layer stack 150a includes a first layer 152, a second layer 154, and a third layer 156. The third layer 156 may be doped lighter than the second layer 154. The second layer 154 may be doped lighter than the first layer 152. The first layer 152 may be doped to approximately 10¹⁸ dopant atoms/cm³ (cubic centimeter). The second layer 154 may be doped to approximately 10¹⁷ dopant atoms/cm³. The third layer 156 may be doped to approximately 10¹⁶ dopant atoms/cm³. A cleaning of the carbon-face side 122 may be performed prior to deposition of the epitaxial layer stack 150a. The cleaning generally includes a hydrogen etching of several hundreds of nanometers to prepare the carbon-face side 122 for the epitaxy growth and to reduce a density of defects. The hydrogen etching may be done by exposure of the carbon-face side 122 of the donor wafer 120 to hydrogen gas while the donor wafer 120 is heated to a high etching temperature. In various embodiments, the etching temperature may be in a range of 1500 °C to 1700 °C. The epitaxial layer stack 150a grown on the carbon-face side 122 generally decreases an overall density of defects in epitaxy layer. Several existing fabrication techniques may be utilized in forming the epitaxial layer stack 150a to improve crystalline quality and induced strain. The van der Waals layer 126 may be formed directly on the third layer 156.

Referring to FIG. 3, a schematic cross-sectional diagram of a second example layer stacking option for an epitaxial layer stack 150b is shown in accordance with one or more exemplary embodiments. The epitaxial layer stack 150b may be formed on the donor wafer 120 before the van der Waals layer 126 is added.

In the embodiment illustrated, the second epitaxial layer stack 150b includes a first layer 162, a second layer 164, a third layer 166, and a fourth layer 168. The fourth layer 168 may be doped heavier than the third layer 166. The third layer 166 may be doped lighter than the second layer 164. The second layer 164 may be doped lighter than the first layer 162. The first layer 162 may be doped to approximately 10¹⁸ atoms/cm³. The second layer 164 may be doped to approximately 10¹⁷ atoms/cm³. The third layer 166 may be doped to approximately 10¹⁶ atoms/cm³. The fourth layer 168 may be doped to approximately 10¹⁸ atoms/cm³ to approximately 10¹⁹ atoms/cm³. A cleaning of the carbon-face side 122 may be performed prior to deposition of the epitaxial layer stack 150b. The cleaning generally includes a hydrogen etching of several hundreds of nanometers to prepare the carbon-face side 122 for the epitaxy growth and to reduce a density of defects. The hydrogen etching may be done by exposure of the carbon-face side 122 of the donor wafer 120 to hydrogen gas while the donor wafer 120 is heated to the high etching temperature. The epitaxial layer stack 150b grown on the carbon-face side 122 generally decreases an overall density of defects in epitaxy layer. Several existing fabrication techniques may be utilized in forming the epitaxial layer stack 150b to improve crystalline quality and induced strain. The van der Waals layer 126 may be formed directly on the fourth layer 168.

Referring to FIG. 4, a schematic cross-sectional diagram of a third example layer stacking option for an epitaxial layer stack 150c is shown in accordance with one or more exemplary embodiments. The epitaxial layer stack 150c may be formed on the donor wafer 120 before the van der Waals layer 126 is added.

In the embodiment illustrated, a doping level of a variable layer 170 in the third epitaxial layer stack 150c is graded from a first side 172 proximate the donor wafer 120 to a second side 174 proximate the van der Waals layer 126. At or near the first side 172, the doping level may be approximately 10¹⁸ atoms/cm³. At or near the second side 174, the doping level may be approximately 10¹⁶ atoms/cm³ to approximately 10¹⁹ atoms/cm³. A cleaning of the carbon-face side 122 may be performed prior to deposition of the epitaxial layer stack 150c. The cleaning generally includes a hydrogen etching of several hundreds of nanometers to prepare the carbon-face side 122 for the epitaxy growth and to reduce a density of defects. The hydrogen etching may be done by exposure of the carbon-face side 122 of the donor wafer 120 to hydrogen gas while the donor wafer 120 is heated to the high etching temperature. The epitaxial layer stack 150c grown on the carbon-face side 122 generally decreases an overall density of defects in epitaxy layer. Several existing fabrication techniques may be utilized in forming the epitaxial layer stack 150c to improve crystalline quality and induced strain. The van der Waals layer 126 may be formed directly on the second side 174 of the variable layer 170.

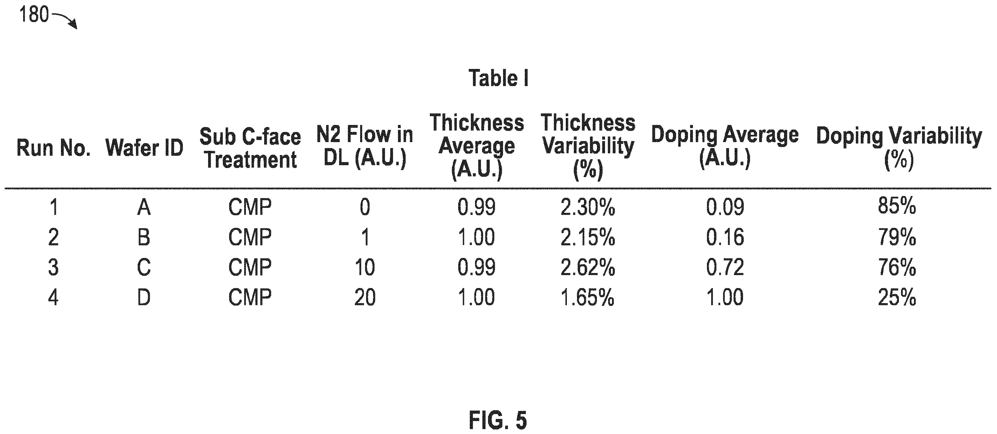

Referring to FIG. 5, a table 180 (e.g., Table I) of example C-face epitaxial growth measurements is shown in accordance with one or more exemplary embodiments. Multiple (e.g., four) wafers were measured at various nitrogen (N₂) flow rates, thickness averages, thickness variability, doping average and doping variability in terms of corresponding normalized arbitrary units (A.U.) and percentages.

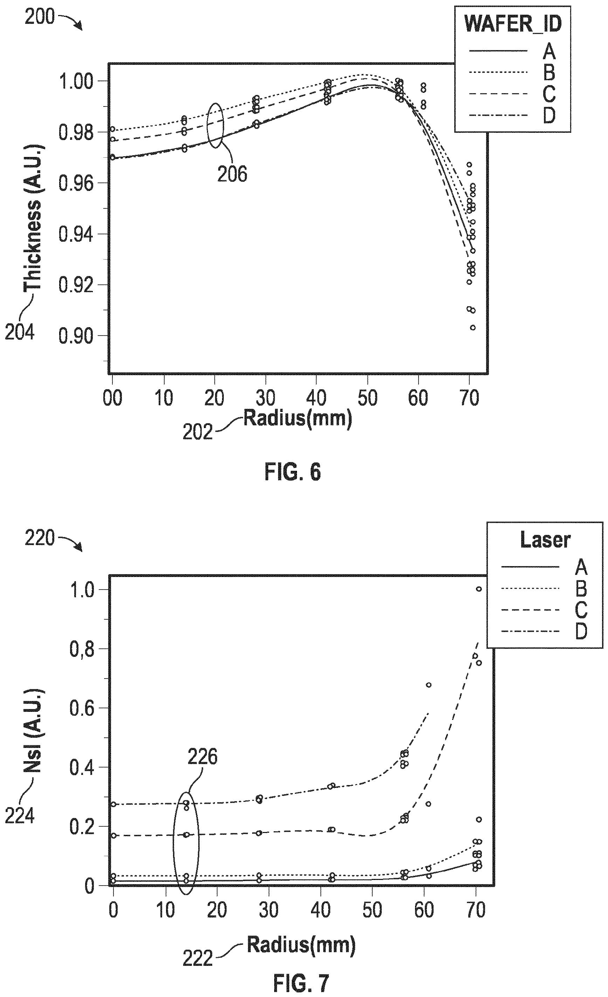

Referring to FIG. 6, a graph 200 of an example C-face epitaxial growth thickness profile as a function of radius is shown in accordance with one or more exemplary embodiments. The graph 200 has an x-axis 202 in terms of radius in units of millimeters (mm). A y-axis 204 has units of thickness normalized to a single arbitrary unit. Multiple curves 206 illustrate the variations of the epitaxial growth thickness for the different wafers shown in Table I (see FIG. 5). The curves 206 illustrate that a maximum growth rate in the example is generally uniform from the center outward with a peak at a radius of around 50 mm. The results were achieved during process testing and the variability may be lower in a final process.

Referring to FIG. 7, a graph 220 of an example C-face epitaxial growth radial doping profiles is shown in accordance with one or more exemplary embodiments. The graph 220 has an x-axis 222 in terms of radius in units of millimeters (mm). A y-axis 224 has units of average doping concentration normalized to a single arbitrary unit. Multiple curves 226 illustrate the variations of doping profiles for the different wafers shown in Table I (see FIG. 5). The curves 226 illustrate that the average doping concentration in the example is generally uniform from the center outward and increases at a radius of around 55 mm. The results were achieved during process testing and the variability may be lower in a final process.

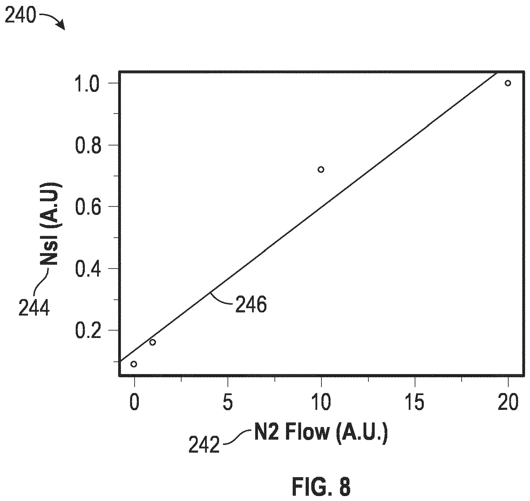

Referring to FIG. 8, a graph 240 of an example calibration curve is shown in accordance with one or more exemplary embodiments. The graph 240 has an x-axis 242 in units of nitrogen (N₂) flow in terms of arbitrary units. A y-axis 244 has units of doping concentration (Nsl) per cubic centimeter normalized to a single arbitrary unit. A curve 246 illustrates a calibration curve based on a center point measurement. The curve 246 illustrates that the doping concentration is generally linearly proportional to the flow rate.

Embodiments of the method and product by process generally utilize direct growth of the future device layer on a graphene spreading layer. The method may include preparation of the C-face of the donor substrate with the hydrogen etching and growth of an epitaxial stack for strain engineered remote epitaxy. The C-face of the donor monocrystalline 4H-SiC substrate may be prepared by hydrogen etching and growing epitaxial stack for strain engineered remote epitaxy. An epitaxial growth of van der Waals layer and the strain engineered remote epitaxy of SiC device layer may be performed in a single epitaxial process on the donor C-face 4H-SiC substrate without intermediate step of Graphene transfer from the donor substrate. The method/device further provides direct bonding of the donor substrate wafer with graphene and SiC epitaxial layer on the handle wafer without intermediate step of additional layer transfer processes. Delamination of the donor monocrystalline 4H-SiC substrate is achieved by application of a stressor layer, ultrasound, or other methods. The delamination may be enhanced by the strain engineered remote epitaxy. A simple refresh process of the donor monocrystalline 4H-SiC substrate after delamination has a potential for multiple (e.g., > 20) reuses.

Clause 1: The above-described method for structure fabrication with silicon carbide (SiC) layer transfer via a remote epitaxy, comprising: forming a van der Waals layer on a donor wafer; growing an epitaxial SiC layer on the van der Waals layer; wafer bonding the epitaxial SiC layer to a handle wafer, wherein the handle wafer is made of polycrystalline SiC; and separating the epitaxial SiC layer from the van der Waals layer to generate a final structure that includes the epitaxial SiC layer on the polycrystalline SiC of the handle wafer.

Clause 2: The method according to clause 1, wherein: the donor wafer is a SiC wafer that has a carbon-face side and a silicon-face side; and the van der Waals layer is formed on the carbon-face side of the SiC wafer.

Clause 3: The method according to clause 2, further comprising: forming an epitaxial layer stack on the carbon-face side of the SiC wafer, wherein the van der Waals layer is formed directly on the epitaxial layer stack.

Clause 4: The method according to clause 3, wherein the forming of the epitaxial layer stack comprises: forming a first layer on the carbon-face side of the SiC wafer; forming a second layer on the first layer, wherein the second layer is doped lighter than the first layer; and forming a third layer on the second layer, wherein the third layer is doped lighter than the second layer.

Clause 5: The method according to clause 4, further comprising: forming a fourth layer on the third layer, wherein the fourth layer is doped heavier than the third layer.

Clause 6: The method according to clause 3 or 4, wherein the forming of the epitaxial layer stack comprises: forming a variable layer on the carbon-face side of the SiC wafer, wherein a doping level in the variable layer is graded from a first side proximate the carbon-face side to a second side proximate the van der Waals layer.

Clause 7: The method according to clause 3 or 4, further comprising: hydrogen etching the epitaxial layer stack prior to the forming of the van der Waals layer.

Clause 8: The method according to any of clauses 1 to 5, wherein the wafer bonding includes: annealing the epitaxial SiC layer and the handle wafer.

Clause 9: The method according to any of clauses 1 to 5, wherein the final structure has an exposed silicon face of the epitaxial SiC layer.

Clause 10: The method according to clause 9, further comprising: chemical mechanical polishing the exposed silicon face of the epitaxial SiC layer.

Clause 11: The method according to any of clauses 1 to 5, wherein the van der Waals layer is one of graphene, and hexagonal boron nitride.

Clause 12: The method according to any of clauses 1 to 5, further comprising: cleaning the van der Waals layer from the donor wafer to prepare the donor wafer for reuse in fabricating another final structure.

Clause 13: The method according to any of clauses 1 to 5, further comprising: polishing the handle wafer prior to bonding to the epitaxial SiC layer.

Clause 14: A silicon carbide structure fabricated according to any of the clauses of clause 1 to 5.

Clause 15: A silicon carbide (SiC) structure comprising: a donor wafer; an epitaxial layer stack formed on the donor wafer; a van der Waals layer formed on the epitaxial layer stack; an epitaxial SiC layer grown on the van der Waals layer; and a handle wafer bonded to the epitaxial SiC layer, wherein the handle wafer is made of a polycrystalline SiC.

Clause 16: The silicon carbide structure according to clause 15, wherein: the donor wafer is a SiC wafer that has a carbon-face side and a silicon-face side; and the epitaxial layer stack is formed on the carbon-face side of the SiC wafer.

Clause 17: The silicon carbide structure according to clause 16, wherein the epitaxial layer stack comprises: a first layer formed on the carbon-face side of the SiC wafer; a second layer formed on the first layer, wherein the second layer is doped lighter than the first layer; and a third layer formed on the second layer, wherein the third layer is doped lighter than the second layer.

Clause 18: The silicon carbide structure according to clause 17, wherein the epitaxial layer stack further comprises: a fourth layer formed on the third layer, wherein the fourth layer is doped heavier than the third layer.

Clause 19: The silicon carbide structure according to clause 16, wherein the epitaxial layer stack comprises: a variable layer formed on the carbon-face side of the SiC wafer, wherein a doping level in the variable layer is graded from a first side proximate the carbon-face side to a second side proximate the van der Waals layer.

Clause 20: The silicon carbide structure according to any of clauses 15 to 19, wherein the van der Waals layer has a thickness in a range of approximately 0.3 nanometers to approximately 1.8 nanometers.

While several modes for carrying out the many aspects of the present teachings have been described in detail, those familiar with the art to which these teachings relate will recognize various alternative aspects for practicing the present teachings that are within the scope of the appended claims. The above description and accompanying drawings are illustrative and exemplary of the entire range of alternative embodiments that an ordinarily skilled artisan would recognize as implied by, structurally and/or functionally equivalent to, or otherwise rendered obvious based upon the included content, and not as limited solely to those explicitly depicted and/or described embodiments.

Moreover, the present concepts expressly include combinations and subcombinations of the described elements and features. The detailed description and the drawings are supportive and descriptive of the present teachings, with the scope of the present teachings defined solely by the claims. Words of approximation, such as "about," "almost," "substantially," "generally," "approximately," and the like, may each be used herein to denote "at, near, or nearly at," or "within 0-5% of," or "within acceptable manufacturing tolerances," or any logical combination thereof, for example.

## Claims

1. A method for structure fabrication with silicon carbide (SiC) layer transfer via a remote epitaxy, comprising:
forming a van der Waals layer on a donor wafer;
growing an epitaxial SiC layer on the van der Waals layer;
wafer bonding the epitaxial SiC layer to a handle wafer, wherein the handle wafer is made of polycrystalline SiC; and
separating the epitaxial SiC layer from the van der Waals layer to generate a final structure that includes the epitaxial SiC layer on the polycrystalline SiC of the handle wafer.

2. The method according to claim 1, wherein:
the donor wafer is a SiC wafer that has a carbon-face side and a silicon-face side; and
the van der Waals layer is formed on the carbon-face side of the SiC wafer.

3. The method according to claim 2, further comprising:
forming an epitaxial layer stack on the carbon-face side of the SiC wafer, wherein the van der Waals layer is formed directly on the epitaxial layer stack.

4. The method according to claim 3, wherein the forming of the epitaxial layer stack comprises:
forming a first layer on the carbon-face side of the SiC wafer;
forming a second layer on the first layer, wherein the second layer is doped lighter than the first layer; and
forming a third layer on the second layer, wherein the third layer is doped lighter than the second layer.

5. The method according to claim 4, further comprising:
forming a fourth layer on the third layer, wherein the fourth layer is doped heavier
than the third layer.

6. The method according to claim 3, wherein the forming of the epitaxial layer stack comprises:
forming a variable layer on the carbon-face side of the SiC wafer, wherein a doping level in the variable layer is graded from a first side proximate the carbon-face side to a second side proximate the van der Waals layer.

7. The method according to claim 3, further comprising:
hydrogen etching the epitaxial layer stack prior to the forming of the van der Waals layer.

8. The method according to claim 1, wherein the wafer bonding includes:
annealing the epitaxial SiC layer and the handle wafer.

9. The method according to claim 1, wherein the final structure has an exposed silicon face of the epitaxial SiC layer.

10. The method according to claim 9, further comprising:
chemical mechanical polishing the exposed silicon face of the epitaxial SiC layer.

11. The method according to claim 1, wherein the van der Waals layer is one of graphene, and hexagonal boron nitride.

12. The method according to claim 1, further comprising:
cleaning the van der Waals layer from the donor wafer to prepare the donor wafer for reuse in fabricating another final structure.

13. The method according to claim 1, further comprising:
polishing the handle wafer prior to bonding to the epitaxial SiC layer.

14. A silicon carbide (SiC) structure comprising:
a donor wafer;
an epitaxial layer stack formed on the donor wafer;
a van der Waals layer formed on the epitaxial layer stack;
an epitaxial SiC layer grown on the van der Waals layer; and
a handle wafer bonded to the epitaxial SiC layer, wherein the handle wafer is made of a polycrystalline SiC.

15. The silicon carbide structure according to claim 14, wherein:
the donor wafer is a SiC wafer that has a carbon-face side and a silicon-face side; and
the epitaxial layer stack is formed on the carbon-face side of the SiC wafer.
